# EUROPEAN PATENT APPLICATION

(11) **EP 0 736 969 A1**
(43) Date of publication of application: **09.10.1996**
(21) Application number: 96302087.0
(22) Date of filing: 26.03.1996
(51) Int. Cl.: H03F 3/72, G11C 7/06

(54) **Differential voltage amplifier**

(30) Priority: 28.03.1995 US 412183
(71) Applicant: TEXAS INSTRUMENTS INCORPORATED, Dallas, Texas 75243 (US)
(72) Inventor: Somasekhar, Dinesh, Basavanagudi, Bangalore--560 032 (IN); Krishnan, R., Ganganagar, , Bangalore--560 032 (IN)
(74) Representative: Holt, Michael

(57) **Abstract**

In a semiconductor sense amplifier for use with a semiconductor memory array, the sense amplifier having two differential amplifiers, (Fig. 2, N1, N2, N5; N3, N4, N5) a semiconductor element (Fig. 2, N7, N8) is placed in the common circuit of each differential amplifier. The common circuit includes the current source (Fig. 2, P1, P2; P4, P5) driving the differential components of each differential amplifier. The control terminals of the semiconductor elements (N7, N8) are coupled to the two output signal terminals of the sense amplifier. In this configuration, the one differential amplifier (N1, N2,N5, or N3, N4, N5) which typically conducts as long as the sense amplifier is enabled, is switched off when one of the input signals on one of the bitlines has decayed. This automatic current conduction termination can provide a power saving and can eliminate the requirement for an sense amplifier enabling signal generator.

## Description

### Field of the Invention

This invention relates generally to amplifier circuits such as those associated with semiconductor memories and, more particularly, to the sense amplifiers that detect or sense the signals from the storage cells of a semiconductor memory array.

### Description of the Related Art

Conventional differential sense amplifiers, of the type used in semiconductor memories, typically consume power as long as the circuit is enabled. This consumption of power results from the path between the supply voltage and the common terminal of one of the two portion of the sense amplifier. Therefore, the designer has to chose a duration for the sense amplifier enable pulse (ENSA) to minimize power consumption. The shorter the duration of the pulse width, the smaller the amount of power consumed during the sensing operation. However, the sense amplifier enable pulse width is subject to the condition that the duration must be sufficiently long for the sensing operation to be complete. The situation is especially aggravated in the case of compiled memories. In compiled memories in which the memory size varies, the time to complete the sensing can vary over a wide range. Typically, the enable sense amplifier pulse is selected to accommodate the slowest access time. In the situation where the random access memory (RAM) size is small, and the access times corresponding short, the longer pulse width will result in excess power consumption because the sensing amplifier is on after the sensing operation is complete.

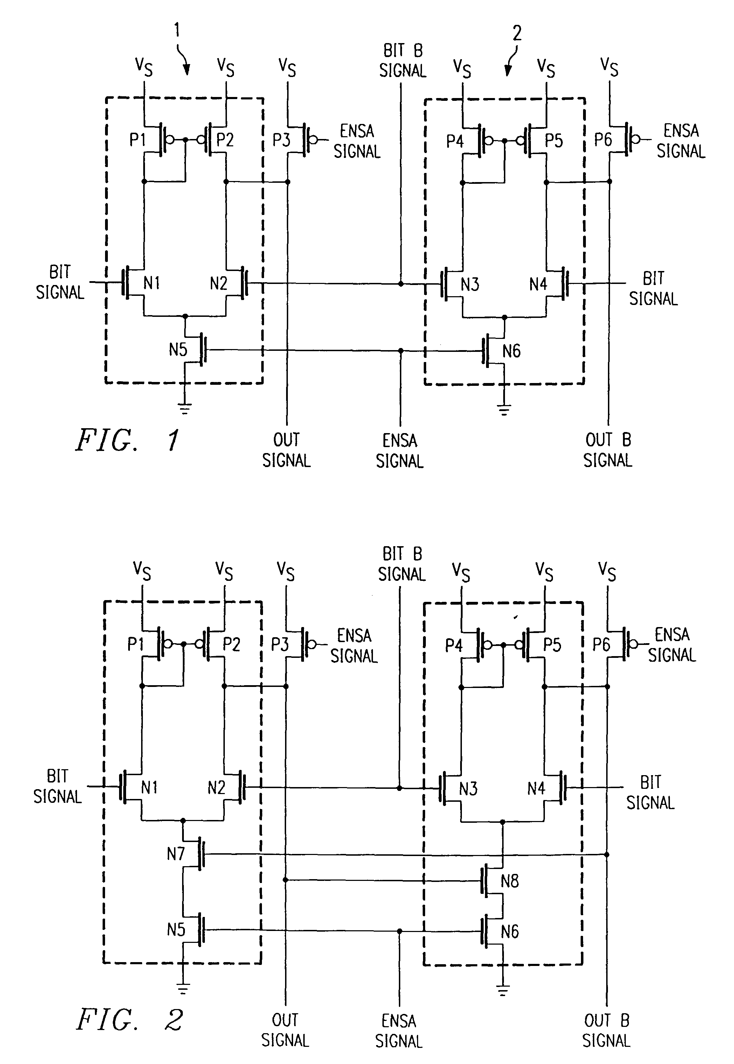

Referring to Fig. 1, a schematic circuit diagram of the differential voltage sense amplifier, according to the related art, is shown. The BIT input terminal is coupled to a gate terminal of n-channel field effect transistor N1. The source terminal of transistor N1 is coupled to a source terminal of n-channel field effect transistor N2 and to the drain terminal of field effect transistor N5. A gate terminal of transistor N5 is coupled to a gate terminal of field effect transistor N6, while a source terminal of transistor N5 is coupled to the common terminal. The drain terminal of transistor N1 is coupled to the drain terminal and the source terminal of p-channel field effect transistor P1 and is coupled to the gate terminal of p-channel field effect transistor P2. The source terminal of transistor P1 is coupled to the Vₛ terminal. The source terminal of transistor P2 is coupled to the Vₛ terminal, while the drain terminal of transistor P2 is coupled to the drain terminal of p-channel field effect transistor P3 and to the output terminal. The source terminal of transistor P3 is coupled to the Vₛ terminal, while the gate terminal of transistor P3 receives the ENSA signal. The gate terminal of transistor N2 is couple to the BITB input terminal and to the gate terminal of n-channel field effect transistor N3. The source terminal of transistor N3 is coupled to the source terminal of n-channel field effect transistor N4 and to the drain terminal of transistor N6, while the drain terminal of transistor N3 is coupled to the drain and the gate terminal of p-channel field effect transistor P4 and is coupled to the gate terminal of p-channel field effect transistor P5. The source terminal of transistor N6 is coupled to the common terminal. The source terminal of transistor P4 is coupled to the Vₛ terminal. The source terminal of transistor P5 is coupled to the Vₛ terminal, while the drain terminal of transistor P5 is coupled to the drain terminal of transistor N4, to the drain terminal of p-channel field effect transistor P6 and to the OUTB terminal. The gate terminal of transistor N4 is coupled to the BIT terminal. The gate terminal of transistor P6 is coupled to the ENSA terminal, while the source terminal of transistor P6 is coupled to the Vₛ terminal. The components of the sense amplifier are conveniently identified with differential amplifier 1 or differential amplifier 2.

The operation of the sense amplifier can be understood as follows. Initially, the sense amplifier has no ENSA (sense amplifier enable) signal applied thereto. The signals applied to the BIT terminal and to the BITB terminal are high and equalized. Both the OUT terminal signal and the OUTB terminal signal are high as a result of the "pull up" effect of transistor P3 and transistor P6. The sense amplifier is enabled by the application of the ENSA signal. The ENSA signal disables transistor P3 and transistor P4, while enabling transistor N5 and N6 (i.e., the current sources). The two portions of the circuit act as differential amplifier 1 and differential amplifier 2, assuming that the BIT terminal remains high and the BITB terminal falls. The OUTB terminal will have a high signal applied thereto and the OUT terminal will have a low signal applied thereto.

The sense amplifier of Fig. 1 has the following limitations. As long as the ENSA signal is high and the BIT terminal is high (by assumption), transistor N1 is conducting thereby providing a path from Vₛ to the common terminal through the (drain-gate shorted) transistor P1 and the (current source) transistor N5. Therefore, this differential amplifier (on the left hand side of Fig. 1) has a continuous power drain. In second differential amplifier, current flows as long as the BITB terminal (which is the falling transition) is greater than the "turn-off" voltage for transistor N3. When the falling transition is slow, as can be case for the typical situation of high fan-in applications, the second differential amplifier can have a substantial conduction of current. However, this power burden is decreasing with time.

In the past, the problem of reducing the power consumption has been addressed by adjusting the ENSA signal duration to be only slightly greater than time needed for the sensing operation, i.e., the time to determine the logic state of the signal from a storage cell. This approach requires a knowledge of the time required for the sense operation. Where many sense amplifiers are coupled to similar circuits, dummy sense amplifiers have been used to provide a control signal which controls the circuits generating the ENSA signal. Neither of these techniques has been satisfactory in reducing the power lost during the normal operation of the differential sense amplifier. In particular, in the case of compiled memories, the time required for the sense operation can vary over a wide range (depending on the RAM size). In the second technique, the use of the dummy storage cells, actually a dummy column in the array, requires a large area, particularly for a small RAM.

A need has therefore been felt for apparatus and a method in a sense amplifier for limiting the consumption of power to the period of time when the sensing operation- is taking place without the necessity of additional control circuitry.

### Summary of the Invention

The aforementioned and other features are accomplished, according to the present invention, by providing a transistor in each of the common portions of the differential amplifiers of the sense amplifier. Each provided transistor is coupled between the divided portion of each differential amplifier and the current source transistor in the common portion of the differential amplifier. The control terminals of the added transistors receive signals from to the output terminals of the sense amplifier. The differential amplifier which typically conducts as long as the sense amplifier is enabled halts current conduction when the signal from the memory cell decays.

These and other features of the present invention will be understood upon reading of the following description along with the figures.

### Brief description of the Drawings

Figure 1 is a schematic diagram of a sense amplifier for use with semiconductor memories according to the prior art.

Figure 2 is a schematic diagram of a sense amplifier for use in semiconductor memories according to the present invention.

### Detailed Description of the Drawings

Figure 1 has been discussed with respect to the related art.

Referring now to Fig. 2, a schematic diagram of the sense amplifier according to the present invention is shown. Comparing Fig. 1 with Fig. 2, Fig. 2 includes two additional n-channel field effect transistors N7 and N8. The source terminal of transistor N7 is coupled to the drain terminal of transistor N5, the drain terminal of transistor N7 is coupled to the source terminals of transistors N1 and N2 thereby replacing the coupling of these terminal to the drain terminal of transistor N5. The gate terminal of transistor N7 is coupled to the OUTB terminal. The source terminal of transistor N8 is coupled to the drain terminal of transistor N6, while the drain terminal of transistor N8 is coupled to the source terminal of transistors N3 and N4 thereby replacing the coupling the to the drain terminal of transistor N6. The gate terminal of transistor N8 is coupled to the OUT terminal.

The operation of the sense amplifier of the present invention can be understood as follows. Initially, the sense amplifier is disabled with no ENSA signal applied thereto. The BIT and the BITB signals are high and equalized. The OUT and the OUTB signals are high because of the "pull up" effect of transistors P3 and P6. The sense amplifier is enabled by the ENSA pulse, the ENSA pulse disabling transistors P3 and P6 and enables transistors N5 and N6, the current sources for each differential amplifier portion. Assuming that the BIT signal remains high and the BITB signal falls, the two portions of the circuit perform as differential amplifiers and the OUT terminal will be driven high while the OUTB terminal will be driven low. Because the OUTB is driven low, the transistor N7 will be cut off. The left differential amplifier which is the major source of power loss is thus disabled. The right differential amplifier portion will continue to consume power until the BITB signal switches off transistor N3.

As will be seen from the foregoing discussion, the sense amplifier of the present invention automatically cuts off the differential amplifier portion of the circuit which, in prior sense amplifiers, provided the direct path from the voltage Vₛ to the common terminal. This results means that even if the ENSA signal is enabled for a long duration, the sense amplifier stops conducting when one of the signals on the bitlines has decayed. Consequently, the ENSA signal pulse can be made sufficiently long to accommodate the longest sensing time requirement without additional impact on the power consumption. The present invention permits the sense amplifier pulse generator to be eliminated. In addition, the frequency response of the sense amplifier is not degraded as long as the current through the sense amplifier is the same as before.

The positive feedback of the cross-coupled transistors does not cause the sense amplifier to latch-up. This failure to provide a latch-up state for the circuit is a result of the current changes caused by these transistors being a common mode signal for the differential amplifier portions. Therefore, assuming an ideal sense amplifier, a change in the gate voltages of transistors N7 and N8 is not reflected in the signals at the OUT and OUTB terminals. However, as a practical matter, the transistor parameters should be selected so that the gain from the gate terminals of transistors N7 and N8 to the OUT and OUTB terminals are less than one.

In case of selected bitline errors, one of the differential amplifier portions to be switched off when the sense amplifier is sensing the wrong value. In this case, the sense amplifier output signal will finally attain the correct value (the sensing operation taking place only in the enabled sense amplifier). The sensing operation will occupy a longer duration.

The sense amplifier of the present invention is particularly useful in the case of compiled memories where the access time varies over a much wider range of time intervals. In such applications, this sense amplifier allows the achievement of lower power without compromising either the frequency response or appreciable area on the semiconductor substrate, the area of two additional amplifiers being negligible.

While the invention has been described with particular reference to the preferred embodiment, it will be understood by those skilled in the art that various changes may be made and equivalents substituted for elements of the preferred embodiment without departing from the invention. For example, the present invention has been described with particular reference to the sensing of signals from a semiconductor memory array. However, the invention has application to sense amplifiers in a variety of roles, the requirement being that of reduction in power. In addition, many modifications can be made to adapt to a particular situation and material to a teaching of the invention without departing from the essential teachings of the present invention.

As is evident from the foregoing discussion, certain aspects of the invention are not limited to the particular details of the examples illustrated, and it is therefore contemplated that other modification and application will occur to those skilled in the art. It is accordingly intended that the calms shall cover all such modifications and applications as do not depart from the spirit and scope of the invention.

## Claims

1. An amplifier comprising:
a first and a second differential amplifier, each differential amplifier having a common terminal, each differential amplifier including a feedback element and a current source, wherein said feedback element is coupled to said common terminal and said current source is coupled to said transistor of said associated differential amplifier, wherein control terminals of said current sources are coupled together, a control terminal of each feedback element being coupled to an output signal of the non-associated differential amplifier.

2. The amplifier of claim 1 wherein in each differential amplifier said feedback element is a first transistor and said current source is a second transistor, each differential amplifier including a third and a fourth transistor coupled in parallel.

3. The amplifier of claim 2 wherein an output signal from each differential amplifier is enabled by a fifth transistor, each of said fifth transistors being activated by an enabling signal.

4. The amplifier of claim 2 wherein each differential amplifier further includes a fifth transistor in series with said third transistor and a sixth transistor coupled in series with said fourth transistor.

5. The amplifier of claim 4 wherein said first, second, third, and fourth transistors are n-channel field effect transistors, and wherein said fifth and sixth transistors are p-channel field effect transistors.

6. The amplifier of claim 5 wherein said differential amplifiers further include a seventh p-channel field effect transistor coupled in parallel with said sixth transistor, said seventh transistor responsive to a control signal for enabling an output terminal of an associated differential amplifier.

7. The sense amplifier of any preceding claim wherein a predetermined differential amplifier halts conduction of current therethrough during decay of an input signal.

8. A method for reducing power in an amplifier, said amplifier including two differential amplifiers, each differential amplifier having a current sources with a control terminal coupled to the control terminal of the other differential amplifier, said method comprising the steps of:
coupling a first transistor between the common terminal and a current source in each of the differential amplifiers; and
coupling a control terminal of each said first transistor to an output terminal of the other differential amplifier.

9. The method of claim 8 further comprising the step of selecting components wherein a gain from an input terminal of each differential amplifier to an output terminal of each differential amplifier is has a gain of less than one.

10. The method of claim 9 wherein said coupling step includes the step of halting current through a predetermined differential amplifier when an input signal has decayed, said predetermined differential amplifier normally conducting when said sense amplifier is enabled.

11. The amplifier of any preceding claim wherein element parameters are selected to prevent latch-up of said sense amplifier.

12. The amplifier of any preceding claim wherein a predetermined differential amplifier, normally conducting when said amplifier is enabled, halts conduction as a input signal decays.

13. The sense amplifier of any preceding claim wherein said feedback elements and said current source transistors are n-channel field effect transistors.

14. The amplifier of claim 13 wherein each differential amplifier further includes a p-channel transistor.

15. The amplifier of claim 14 further including a p-channel enabling transistor coupled in parallel with a selected p-channel transistor, said enabling transistor responsive to an enabling signal for activating said sense amplifier.

16. The amplifier of any preceding claim wherein element parameters are selected to provide a gain of less than one from an input terminal to an output terminal.

17. An amplifier as claimed in any preceding claim, said amplifier being a sense amplifier.

18. A memory including an amplifier as claimed in any preceding claim.
